# EUROPÄISCHE PATENTSCHRIFT

(11) **EP 2 463 899 B1**
(45) Veröffentlichungstag und Bekanntmachung des Hinweises auf die Patenterteilung: **06.01.2016**
(21) Anmeldenummer: 11185631.6
(22) Anmeldetag: 18.10.2011
(51) Int. Cl.: H01L 23/00, H01L 23/04, H01L 23/40, H01L 25/07, H01L 23/48, H01L 23/552

(54) **Halbleiterschaltungsanordnung**
Semiconductor circuit assembly
Agencement de commutation semi-conducteur

(30) Priorität: 07.12.2010 DE 102010062556
(43) Veröffentlichungstag der Anmeldung: 13.06.2012
(73) Patentinhaber: SEMIKRON Elektronik GmbH & Co. KG, 90431 Nürnberg (DE)
(72) Erfinder: Dr. Besendörfer, Kurt-Georg, 90556 Cadolzburg (DE); Göbl, Christian, 90441 Nürnberg (DE)

(56) Entgegenhaltungen:
- EP-A1- 1 024 530
- EP-A1- 1 403 923
- EP-A2- 1 376 690
- DE-A1-102008 045 614
- DE-A1-102009 002 191
- US-A1- 2009 261 472

## Beschreibung

Die Erfindung betrifft eine Halbleiterschaltungsanordnung mit einem Gehäuse für ein Schaltungssubstrat, das Halbleiterbauelemente aufweist und das an einem Kühlkörper vorgesehen ist, wobei das Gehäuse mit Druckelementen ausgebildet ist.

Aus der DE 199 03 875 C2 ist eine Halbleiterschaltungsanordnung in Druckkontaktierung bekannt, bei der es sich insbesondere um einen Stromumrichter handelt. Diese bekannte Halbleiterschaltungsanordnung besteht aus einem Treiber und mindestens einem Gehäuse, das ein Schaltungssubstrat mit Halbleiterbauelementen aufweist. Zwischen dem Treiber und dem Gehäuse ist eine Druckplatte zum Aufbau eines konstanten Anpreßdruckes angeordnet. Die Druckplatte weist eine in Kunststoff eingebettete Metalleinlage mit isolierten Durchführungen für elektrische Kontakte auf. Das Gehäuse ist materialeinstückig mit Druckelementen ausgebildet, die dazu vorgesehen sind, das Schaltungssubstrat gegen einen Kühlkörper zu pressen, um einen gewünschten Wärmeübergang vom Schaltungssubstrat zum Kühlkörper zu bewirken. Diese thermische Kopplung kann jedoch noch Wünsche offen lassen.

Aus der US 2009/0261472 A1 ist ein Halbleitermodul mit einem Presselement, das einen Druck auf einen Leistungshalbleiterchip des Halbleitermoduls ausübt, bekannt.

Aus der DE 10 2009 002 191 A1 ist ein Leistungshalbleitermodul, das auf einem Kühlkörper montierbar ist und einen Leistungshalbleiterchip, der auf einem Substrat angeordnet ist, bekannt.

Aus der DE 10 2008 045 614 A1 ist eine Anordnung umfassend ein Halbleiterbauelement und ein Drahtbauteil, das zur Kontaktierung des Halbleiterbauelements elastisch vorgespannt mit einer Stirnseite an einer Oberflächenschicht des Halbleiterbauelementes anliegt, wobei die Oberflächenschicht ein Material mit härterer Oberfläche umfasst als die Stirnseite des Drahtbauteils, bekannt.

Aus der EP 1 403 923 A1 ist ein Leistungshalbleitermodul, das eine Schicht aufweist, die in einem direkten Kontakt mit einer Hauptelektrode eines Halbleiterchips steht, bekannt.

Aus der EP 1 376 690 A2 ist eine druckkontaktierte Halbleitervorrichtung, die eine Mehrzahl von Halbleiterchips und eine erste Wärmepufferplatte, die auf einer Oberflächenseite der mehreren Halbleiterchips angeordnet ist, bekannt.

Aus der EP 1 024 530 A1 ist ein Leistungshalbleitermodul mit einer Basisplatte, einer Deckplatte und mit mindestens einem Halbleiterchip, welcher mit einer ersten Hauptelektrode und mit der Basisplatte in elektrischer Verbindung steht und welcher mit einer zweiten Hauptelektrode über ein gefedertes elektrisches Kontaktelement mit der Deckplatte in elektrischer Verbindung steht, bekannt.

Der Erfindung liegt die Aufgabe zugrunde, eine Halbleiterschaltungsanordnung zu schaffen, bei welcher die thermische Kopplung des Schaltungssubstrates mit dem Kühlkörper auf einfache Weise verbessert ist.

Diese Aufgabe wird erfindungsgemäß durch die Merkmale des Anspruchs 1 gelöst.

Es ergibt sich der Vorteil, dass die Druckkraft, mit welcher die Druckelemente mittelbar oder unmittelbar am Schaltungssubstrat wirksam werden, umso größer sind, je wärmer die Halbleiterschaltungsanordnung ist, so dass der thermische Widerstand zwischen dem Schaltungssubstrat und dem Kühlkörper entsprechend verkleinert wird.

Erfindungsgemäß ist das Gehäuse der Halbleiterschaltungsanordnung mit Kavitäten für die Druckkörper ausgebildet, wobei die Druckkörper mit einem Kopfabschnitt aus der jeweils zugehörigen Kavität vorstehen, so dass der jeweilige Kopfabschnitt mittelbar oder unmittelbar gegen das Schaltungssubstrat wirksam wird.

Der Kopfabschnitt des jeweiligen Druckkörpers kann noppenförmig ausgebildet sein, um ein Gehäuse mit thermomechanischen Kraftnoppen zu realisieren.

Zur mechanischen Versteifung des Gehäuses, das aus einem Kunststoffmaterial wie beispielsweise PPS besteht, d.h. um seine Formstabilität weiter zu verbessern, kann es vorteilhaft sein, wenn dem jeweils mindestens einen Druckkörper des Gehäuses eine Metalleinlage zugeordnet ist, die in das Gehäuse eingebettet ist. Die Metalleinlage kann von einem Metallblech gebildet sein.

Bei der erfindungsgemäßen Halbleiterschaltungsanordnung können die Druckkörper der Druckelemente dem Schaltungssubstrat unmittelbar zugeordnet sein. Desgleichen ist es möglich, dass der mindestens eine Druckkörper mindestens eines Druckelementes einem Halbleiterbauelement zugeordnet ist, so dass dieser Druckkörper über das zugehörige Halbleiterbauelement mittelbar am Schaltungssubstrat wirksam wird, um dieses gegen den Kühlkörper zu pressen. Des Weiteren ist es möglich, dass die Druckkörper einer Anzahl erster Druckelemente dem Schaltungssubstrat und die Druckkörper einer Anzahl zweiter Druckelemente Halbleiterbauelementen zugeordnet sind.

Erfindungsgemäß können die Druckkörper beispielsweise aus einem Silikonmaterial bestehen, das in zugehörige Kavitäten des Gehäuses spritzgußtechnisch eingebracht wird. Im Betrieb erwärmt sich die Halbleiterschaltungsanordnung, wobei sich das Silikonmaterial stärker ausdehnt als das dieses umgebende Gehäusematerial. Beispielsweise beträgt das Verhältnis des Wärmeausdehnungskoeffizienten von Silikon zum Wärmeausdehnungskoeffizienten von PPS 300 ppm zu 30 ppm. Die hieraus resultierende Volumenänderung bildet eine thermomechanische Kraft, die erfindungsgemäß dazu genutzt wird, um das Schaltungssubstrat gegen den Kühlkörper der Halbleiterschaltungsanordnung zu pressen und auf diese Weise eine optimale Wärmeableitung zum Kühlkörper zu bewirken.

Weitere Einzelheiten, Merkmale und Vorteile ergeben sich aus der nachfolgenden Beschreibung in Verbindung mit der anliegenden Zeichnung.

Es zeigen:
Figur 1 in einer Seitenansicht abschnittweise und teilweise aufgeschnitten, nicht maßstabgetreu in einem vergrößerten Maßstab eine erste Ausführungsform der erfindungsgemäßen Halbleiterschaltungsanordnung, und
Figur 2 in einer der Figur 1 ähnlichen schematischen Darstellung eine zweite Ausführungsform der erfindungsgemäßen Halbleiterschaltungsanordnung.

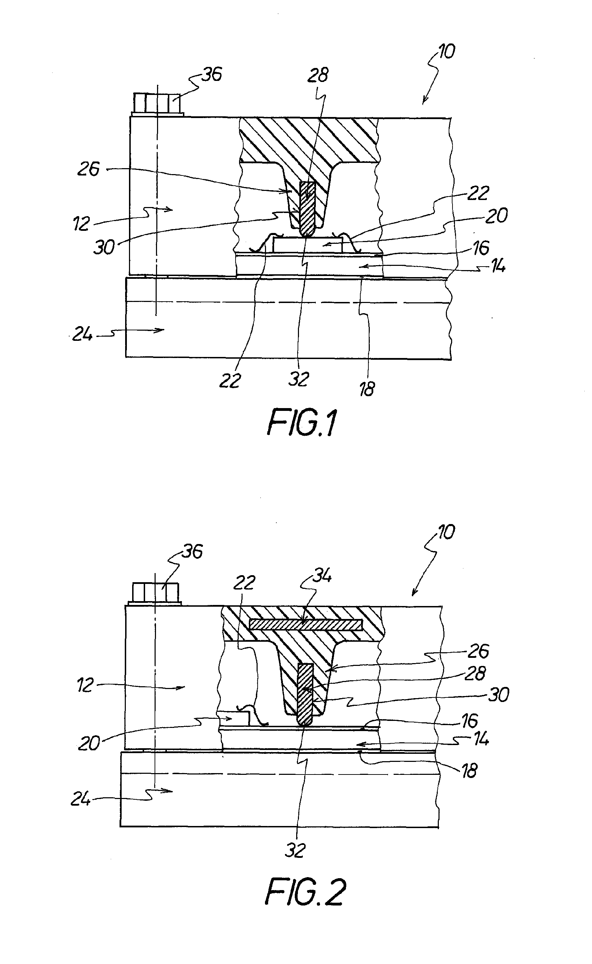

Figur 1 zeigt abschnittweise eine Halbleiterschaltungsanordnung 10 mit einem aufgeschnitten gezeichneten Gehäuse 12 für ein Schaltungssubstrat 14. Das Schaltungssubstrat 14 weist an seiner einen Seite eine schaltstrukturierte Metallisierung 16 und an seiner davon abgewandten zweiten Seite eine Metallisierung 18 auf. Am Schaltungssubstrat 14 sind Halbleiterbauelemente 20 vorgesehen, die mittels der schaltstrukturierten Metallisierung 16 verschaltet sind. Zur Verschaltung sind beispielsweise Bonddrähtchen 22 vorgesehen.

Bei den Halbleiterbauelementen 20 handelt es sich insbesondere um Leistungshalbleiterbauelemente, um eine Leistungshalbleiterschaltungsanordnung zu realisieren.

Zur Wärmeableitung ist ein Kühlkörper 24 vorgesehen, an welchem das Schaltungssubstrat 14 mit seiner Metallisierung 18 großflächig anliegt.

Eine optimale Wärmeableitung vom Schaltungssubstrat 14 zum Kühlkörper 24 wird erzielt, wenn das Schaltungssubstrat 14 mit einer entsprechenden Anpreßkraft gegen den Kühlkörper 24 gepresst wird. Zu diesem Zwecke ist das Gehäuse 12 materialeinstückig mit Druckelementen 26 ausgebildet. Erfindungsgemäß weisen die Druckelemente 26 jeweils einen Druckkörper 28 auf, der aus einem Material besteht, dessen Wärmeausdehnungskoeffizient größer ist als der Wärmeausdehnungskoeffizient des Materials des Gehäuses 12 bzw. des entsprechenden Druckelementes 26.

Das Gehäuse 12 bzw. das jeweilige Druckelement 26 ist mit einer Kavität 30 für einen zugehörigen Druckkörper 28 ausgebildet. Der Druckkörper 28 ist derartig dimensioniert, dass er aus dem zugehörigen Druckelement 26 mit einem Kopfabschnitt 32 vorsteht. Bei dem in Figur 1 gezeichneten Ausführungsbeispiel der Halbleiterschaltungsanordnung 10 liegt der Kopfabschnitt 32, der noppenförmig ausgebildet ist, an einem Halbleiterbauelement 20 an und drückt im Betrieb der Halbleiterschaltungsanordnung 10, d.h. bei der jeweiligen erhöhten Betriebstemperatur, gegen das entsprechende Halbleiterbauelement 20 und somit mittelbar das Schaltungssubstrat 14 gegen den Kühlkörper 24. Demgegenüber verdeutlicht die Figur 2, in der gleiche Einzelheiten mit den selben Bezugsziffern wie in Figur 1 bezeichnet sind, dass der jeweilige Druckkörper 28 nicht mittelbar über ein Halbleiterbauelement 20 sondern unmittelbar gegen das Schaltungssubstrat 14 und dieses gegen den Kühlkörper 12 drückt. Außerdem verdeutlicht die Figur 2 eine Metalleinlage 34, die von einem Metallblech gebildet ist, das in das Gehäuse 12 spritzgußtechnisch eingebettet ist. Die Metalleinlage 34 ist dem jeweiligen Druckkörper 28 zugeordnet und bewirkt eine Erhöhung der Formstabilität des Gehäuses 12.

Mittels Schrauben, von welchen nur eine Schraube 36 gezeichnet ist, ist das Gehäuse 12 mit dem Kühlkörper 24 in an sich bekannter Weise verschraubt.

### Bezugsziffernliste:

- 10: Halbleiterschaltungsanordnung
- 12: Gehäuse (von 10 für 14)
- 14: Schaltungssubstrat (von 10)
- 16: schaltstrukturierteMetalllage (von 14)
- 18: Metalllage (von 14)
- 20: Halbleiterbauelement (von 10 an 16)
- 22: Bonddrähtchen (zwischen 20 und 16)
- 24: Kühlkörper (von 10)
- 26: Druckelemente (von 12 für 14)
- 28: Druckkörper (von 26)
- 30: Kavität (in 26 für 28)
- 32: Kopfabschnitt (von 28)
- 34: Metalleinlage (in 12)
- 36: Schraube (von 10 zwischen 12 und 24)

## Patentansprüche

1. Halbleiterschaltungsanordnung mit einem Gehäuse (12) für ein Schaltungssubstrat (14), das Halbleiterbauelemente (20) aufweist und das an einem Kühlkörper (24) vorgesehen ist, **dadurch gekennzeichnet, dass** das Gehäuse (12) einstückig mit Druckelementen (26) ausgebildet ist,
wobei die Druckelemente (26) des Gehäuses (12) jeweilig mit einer Kavität (30) für einen zugehörigen Druckkörper (28) ausgebildet sind, wobei die Druckkörper (28) mit einem Kopfabschnitt (32) aus der jeweils zugehörigen Kavität (30) vorstehen, wobei die Druckkörper (28) ausschließlich aus einem Material bestehen, wobei dessen Wärmeausdehnungskoeffizient größer ist als der Wärmeausdehnungskoeffizient des Materials des Gehäuses (12).

2. Halbleiterschaltungsanordnung nach einem der Ansprüche 1,
**dadurch gekennzeichnet,**
**dass** dem jeweiligen Druckkörper (28) eine Metalleinlage (34) zugeordnet ist, die in das Gehäuse (12) eingebettet ist.

3. Halbleiterschaltungsanordnung nach Anspruch 2,
**dadurch gekennzeichnet,**
**dass** die Metalleinlage (34) von einem Metallblech gebildet ist.

4. Halbleiterschaltungsanordnung nach einem der Ansprüche 1 bis 3,
**dadurch gekennzeichnet,**
**dass** die Druckkörper (28) dem Schaltungssubstrat (14) zugeordnet sind.

5. Halbleiterschaltungsanordnung nach einem der Ansprüche 1 bis 3,
**dadurch gekennzeichnet,**
**dass** mindestens ein Druckkörper (28) einem Halbleiterbauelement (20) zugeordnet ist.

6. Halbleiterschaltungsanordnung nach einem der Ansprüche 1 bis 3,
**dadurch gekennzeichnet,**
**dass** eine Anzahl der Druckkörper (28) dem Schaltungssubstrat (14) und eine Anzahl der Druckkörper (28) den Halbleiterbauelementen (20) zugeordnet sind.

## Claims

1. Semiconductor circuit assembly with a housing (12) for a circuit substrate (14), which has semiconductor components (20) and is provided on a cooling body (24), **characterized in that** the housing (12) is formed in one piece with pressure elements (26), wherein the pressure elements (26) of the housing (12) are respectively formed with a cavity (30) for an associated pressure body (28), wherein the pressure bodies (28) protrude with a head portion (32) from the respectively associated cavity (30), wherein the pressure bodies (28) consist exclusively of a material that has a greater coefficient of thermal expansion than the coefficient of thermal expansion of the material of the housing (12).

2. Semiconductor circuit assembly according to Claim 1,
**characterized**
**in that** the respective pressure body (28) is assigned a metal inlay (34), which is embedded in the housing (12).

3. Semiconductor circuit assembly according to Claim 2,
**characterized**
**in that** the metal inlay (34) is formed by a metal sheet.

4. Semiconductor circuit assembly according to one of Claims 1 to 3,
**characterized**
**in that** the pressure bodies (28) are assigned to the circuit substrate (14).

5. Semiconductor circuit assembly according to one of Claims 1 to 3,
**characterized**
**in that** at least one pressure body (28) is assigned to a semiconductor component (20).

6. Semiconductor circuit assembly according to one of Claims 1 to 3,
**characterized**
**in that** a number of the pressure bodies (28) are assigned to the circuit substrate (14) and a number of the pressure bodies (28) are assigned to the semiconductor components (20).

## Revendications

1. Dispositif de circuit à semiconducteur comportant un boîtier (12) destiné à un substrat de circuit (14) qui comprend des composants semiconducteurs (20) et qui est disposé sur un dissipateur thermique (24), **caractérisé en ce que** le boîtier (12) est réalisé solidaire d'éléments d'impression (26), dans lequel les éléments d'impression (26) du boîtier (12) sont respectivement réalisés de manière à comporter une cavité (30) destinée à un dissipateur thermique associé (28), dans lequel les dissipateurs thermiques (28) ont une section de tête (32) faisant saillie hors de la cavité respectivement associée (30), dans lequel les dissipateurs thermiques (28) sont exclusivement constitués d'un matériau, dont le coefficient de dilatation thermique est supérieur au coefficient de dilatation thermique du matériau du boîtier (12).

2. Dispositif de circuit à semiconducteur selon la revendication 1,
**caractérisé en ce qu'**un insert métallique (34) qui est incorporé au boîtier (12) est associé au dissipateur thermique respectif (28).

3. Dispositif de circuit à semiconducteur selon la revendication 2,
**caractérisé en ce que** l'insert métallique (34) est formé d'une tôle métallique.

4. Dispositif de circuit à semiconducteur selon l'une quelconque des revendications 1 à 3,
**caractérisé en ce que** le dissipateur thermique (28) est associé au substrat de circuit (14).

5. Dispositif de circuit à semiconducteur selon l'une quelconque des revendications 1 à 3,
**caractérisé en ce qu'**au moins un corps d'impression (28) est associé à un composant à semiconducteur (20).

6. Dispositif de circuit à semiconducteur selon l'une quelconque des revendications 1 à 3,
**caractérisé en ce qu'**un certain nombre des dissipateurs thermiques (28) est associé au substrat de circuit (14) et **en ce qu'**un certain nombre des dissipateurs thermiques (28) est associé aux composants à semiconducteur (20).
